# EUROPEAN PATENT APPLICATION

(11) **EP 4 697 614 A1**
(43) Date of publication of application: **18.02.2026**
(21) Application number: 23936877.2
(22) Date of filing: 12.05.2023
(51) Int. Cl.: H04B 7/0456

(54) **COMMUNICATION METHOD, COMMUNICATION APPARATUS, AND COMMUNICATION SYSTEM**

(71) Applicant: Huawei Technologies Co., Ltd., Shenzhen, Guangdong 518129 (CN)
(72) Inventor: DONG, Lei, Shenzhen, Guangdong 518129 (CN); TANG, Hao, Shenzhen, Guangdong 518129 (CN); WANG, Ting, Shenzhen, Guangdong 518129 (CN); GAO, Na, Shenzhen, Guangdong 518129 (CN); WEI, Dongdong, Shenzhen, Guangdong 518129 (CN); MA, Jianglei, Shenzhen, Guangdong 518129 (CN)
(74) Representative: MERH-IP Matias Erny Reichl Hoffmann Patentanwälte PartG mbB
(86) International application number: PCT/CN2023/094063
(87) International publication number: WO 2024/234187

(57) **Abstract**

Embodiments of this application provide a communication method, a communication apparatus, and a communication system. The method includes: determining a first codebook, where the first codebook is for quantizing first data; and sending first indication information, where the first indication information indicates the first codebook. In this solution, the first data is quantized by using the codebook, so that transmission resource overheads during data transmission can be reduced.

## Description

### TECHNICAL FIELD

This application relates to the field of communication technologies, and in particular, to a communication method, a communication apparatus, and a communication system.

### BACKGROUND

With development of communication technologies, there is an increasing demand for transmission of large-scale data between devices. When large-scale data is exchanged between different devices, huge transmission resource overheads are caused.

When transmission resources become increasingly scarce, how to perform transmission of large-scale data is an urgent problem to be resolved.

### SUMMARY

This application provides a communication method, a communication apparatus, and a communication system, to reduce transmission resource overheads during data transmission.

According to a first aspect, an embodiment of this application provides a communication method. The method is performed by a first apparatus. The first apparatus may be a terminal device, a network device, or another device, or a module in the terminal device, the network device, or the another device. The method includes: determining a first codebook, where the first codebook is for quantizing first data; and sending first indication information, where the first indication information indicates the first codebook.

In the foregoing solution, the first data is quantized by using the codebook, so that transmission resource overheads during data transmission can be reduced.

In a possible implementation, determining the first codebook includes: determining a first codebook set based on a distribution feature of the first data, where the first codebook set includes at least one codebook; and determining the first codebook in the first codebook set.

In the foregoing solution, the first codebook set is determined with reference to the distribution feature of the first data, and the first codebook is determined from the first codebook set. This helps determine an appropriate codebook, to reduce data transmission overheads.

In a possible implementation, determining the first codebook in the first codebook set includes: determining the first codebook based on a transmission overhead corresponding to the codebook in the first codebook set.

In the foregoing solution, the first codebook is determined from the first codebook set based on the transmission overhead corresponding to the codebook in the first codebook set. This helps determine an appropriate codebook, to reduce data transmission overheads.

In a possible implementation, the transmission overhead includes a codebook indication overhead and/or a data transmission overhead for quantized first data.

In a possible implementation, determining the first codebook in the first codebook set includes: sending first information, where the first information indicates a part or all of codebooks in the first codebook set; receiving second information, where the second information indicates that a part or all of the codebooks indicated by the first information are used; and determining the first codebook based on the second information.

In the foregoing solution, the first apparatus and a second apparatus jointly determine the first codebook corresponding to the first data, so that it can be ensured that the determined first codebook can satisfy quantization performance, and data transmission overheads are reduced.

In a possible implementation, a transmission overhead corresponding to the codebook indicated by the first information is less than a transmission overhead threshold.

In a possible implementation, determining the first codebook in the first codebook set includes: receiving third information, where the third information indicates the first codebook.

In the foregoing solution, the second apparatus determines the first codebook corresponding to the first data, so that it can be ensured that the determined first codebook can satisfy quantization performance, and data transmission overheads are reduced.

In a possible implementation, a quantization error of the codebook in the first codebook set is less than or equal to a quantization error threshold.

In the foregoing solution, the quantization error of the codebook in the first codebook set is less than or equal to the quantization error threshold, so that the determined first codebook in the first codebook set is also less than or equal to the quantization error threshold. This helps determine an appropriate codebook, to reduce data transmission overheads.

In a possible implementation, the quantization error threshold is preconfigured or predefined.

In a possible implementation, the quantization error threshold is related to an importance degree of the first data.

In the foregoing solution, the quantization error threshold is determined based on the importance degree of the first data. This helps determine an appropriate codebook for the first data.

In a possible implementation, determining the first codebook set based on the distribution feature of the first data includes: determining, based on the distribution feature of the first data and a mapping relationship between the distribution feature and a codebook, the first codebook set that is in the mapping relationship and that corresponds to the distribution feature of the first data.

In the foregoing solution, the mapping relationship between the distribution feature and the codebook is preconfigured, and subsequently, the first codebook corresponding to the first data may be determined based on the mapping relationship and the distribution feature of the first data, so that quick determining of the codebook corresponding to the first data can be implemented, to reduce a data transmission delay.

In a possible implementation, the distribution feature of the first data includes a data distribution slope and/or a data expectation.

In a possible implementation, the first codebook satisfies a preset modulation and coding scheme MCS requirement.

In a possible implementation, the first data is associated with a first service, a first data radio bearer, or a first logical channel.

In a possible implementation, the method further includes: quantizing the first data to obtain quantized data; determining, based on the first codebook, a codeword corresponding to the quantized data; and sending the codeword corresponding to the quantized data.

In the foregoing solution, the first data is quantized by using the codebook, so that transmission resource overheads during data transmission can be reduced.

In a possible implementation, the method further includes: determining a second codebook, where the second codebook is for quantizing second data; and sending second indication information, where the second indication information indicates the second codebook.

In the foregoing solution, the second data is quantized by using the codebook, so that transmission resource overheads during data transmission can be reduced.

In a possible implementation, the first data and the second data correspond to a same artificial intelligence model.

According to a second aspect, an embodiment of this application provides a communication method. The method is performed by a second apparatus or a module in the second apparatus. The second apparatus may be a terminal device, a network device, or another device, or a module in the terminal device, the network device, or the another device. The method includes: receiving first indication information, where the first indication information indicates a first codebook, and the first codebook is for quantizing first data; and determining the first codebook based on the first indication information.

In the foregoing solution, the first data is quantized by using the codebook, so that transmission resource overheads during data transmission can be reduced.

In a possible implementation, the method further includes: receiving a codeword corresponding to quantized data, where the quantized data is obtained by quantizing the first data.

In the foregoing solution, the first data is quantized by using the codebook, so that transmission resource overheads during data transmission can be reduced.

In a possible implementation, the method further includes: determining the quantized data based on the first codebook and the codeword corresponding to the quantized data.

In a possible implementation, the method further includes: receiving first information, where the first information indicates a part or all of codebooks in a first codebook set; and sending second information, where the second information indicates that a part or all of the codebooks indicated by the first information are used, and the codebook indicated by the second information includes the first codebook.

In the foregoing solution, a first apparatus and the second apparatus jointly determine the first codebook corresponding to the first data, so that it can be ensured that the determined first codebook can satisfy quantization performance, and data transmission overheads are reduced.

In a possible implementation, a transmission overhead corresponding to the codebook indicated by the first information is less than a transmission overhead threshold.

In a possible implementation, the transmission overhead includes a codebook indication overhead and/or a data transmission overhead for quantized first data.

In a possible implementation, a quantization error of the codebook in the first codebook set is less than or equal to a quantization error threshold.

In the foregoing solution, the quantization error of the codebook in the first codebook set is less than or equal to the quantization error threshold, so that the determined first codebook in the first codebook set is also less than or equal to the quantization error threshold. This helps determine an appropriate codebook, to reduce data transmission overheads.

In a possible implementation, the quantization error threshold is preconfigured or predefined.

In a possible implementation, the quantization error threshold is related to an importance degree of the first data.

In the foregoing solution, the quantization error threshold is determined based on the importance degree of the first data. This helps determine an appropriate codebook for the first data.

In a possible implementation, the method further includes: sending third information, where the third information indicates the first codebook.

In the foregoing solution, the second apparatus determines the first codebook corresponding to the first data, so that it can be ensured that the determined first codebook can satisfy quantization performance, and data transmission overheads are reduced.

In a possible implementation, the first codebook satisfies a preset modulation and coding scheme MCS requirement.

In a possible implementation, the first data is associated with a first service, a first data radio bearer, or a first logical channel.

In a possible implementation, the method further includes: receiving second indication information, where the second indication information indicates a second codebook, and the second codebook is for quantizing second data; and determining the second codebook based on the second indication information.

In the foregoing solution, the second data is quantized by using the codebook, so that transmission resource overheads during data transmission can be reduced.

In a possible implementation, the first data and the second data correspond to a same artificial intelligence model.

According to a third aspect, an embodiment of this application provides a communication apparatus. The apparatus has a function of implementing any implementation in the first aspect and the second aspect. The function may be implemented by hardware, or may be implemented by hardware executing corresponding software. The hardware or the software includes one or more modules corresponding to the function.

According to a fourth aspect, an embodiment of this application provides a communication apparatus. The communication apparatus includes a unit or means (means) configured to perform steps of any implementation in the first aspect and the second aspect.

According to a fifth aspect, an embodiment of this application provides a communication apparatus. The communication apparatus includes at least one processor. The processor is configured to run at least one of the following: computer instructions, a program, or a logic circuit, to perform any implementation in the first aspect and the second aspect.

In a possible implementation, the processor is coupled to a memory, and the memory stores the foregoing computer instructions or a program. Alternatively, the memory stores a configuration file of the logic circuit. Optionally, the memory may be located in the apparatus. In other words, the apparatus includes the memory. Optionally, the processor and the memory are integrated together. Optionally, the memory may alternatively be located outside the apparatus.

In a possible implementation, the communication apparatus further includes an interface circuit, and the interface circuit is configured to input and/or output a signal. The processor is configured to communicate with another apparatus by using the interface circuit.

In a possible implementation, the communication apparatus is a chip.

According to a sixth aspect, an embodiment of this application further provides a computer program product. The computer program product includes a computer program or instructions. When the computer program or the instructions are run by a communication apparatus, any implementation in the first aspect and the second aspect is performed.

According to a seventh aspect, an embodiment of this application further provides a computer-readable storage medium. The computer-readable storage medium stores instructions, and when the instructions are run on a communication apparatus, any implementation in the first aspect and the second aspect is performed.

According to an eighth aspect, an embodiment of this application further provides a chip system. The chip system includes a processor, configured to perform any implementation in the first aspect and the second aspect.

According to a ninth aspect, an embodiment of this application further provides a communication system. The communication system includes a first apparatus configured to perform any implementation in the first aspect, and a second apparatus configured to perform any implementation in the second aspect.

### BRIEF DESCRIPTION OF DRAWINGS

FIG. 1 is a diagram of an architecture of a communication system to which an embodiment of this application is applied;
FIG. 2 is a schematic flowchart of a communication method according to an embodiment of this application;
FIG. 3 is an example diagram of a scalar quantization manner;
FIG. 4 is an example diagram of two-dimensional vector quantization;
FIG. 5 is an example diagram of a grouping manner;
FIG. 6 is an example diagram of another grouping manner;
FIG. 7 is a diagram of a CDF distribution slope;
FIG. 8 is a diagram of a PDF distribution slope;
FIG. 9 is a schematic flowchart of a communication method according to an embodiment of this application;
FIG. 10 is a schematic flowchart of a communication method according to an embodiment of this application;
FIG. 11 is a diagram of a structure of a communication apparatus according to an embodiment of this application; and
FIG. 12 is a diagram of a structure of a communication apparatus according to an embodiment of this application.

### DESCRIPTION OF EMBODIMENTS

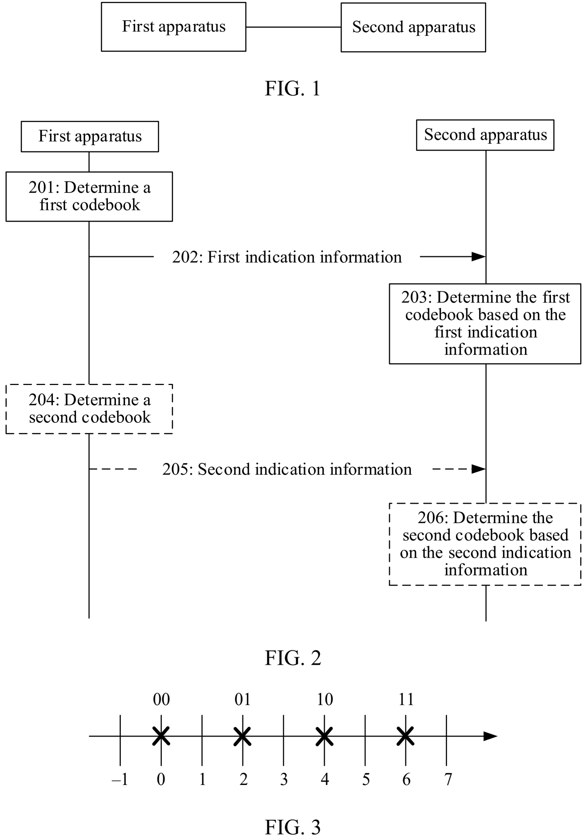

FIG. 1 is a diagram of an architecture of a communication system to which an embodiment of this application is applied. The communication system includes a first apparatus and a second apparatus.

In an implementation, the first apparatus is a network device or a module used in the network device, and the second apparatus is a terminal device or a module used in the terminal device. The first apparatus communicates with the second apparatus through an air interface.

In another implementation, the first apparatus is a terminal device or a module used in the terminal device, and the second apparatus is a network device or a module used in the network device. The first apparatus communicates with the second apparatus through an air interface.

In another implementation, the first apparatus is a network device or a module used in the network device, and the second apparatus is a network device or a module used in the network device. The first apparatus communicates with the second apparatus through an air interface or in a wired manner.

In another implementation, the first apparatus is a terminal device or a module used in the terminal device, and the second apparatus is a terminal device or a module used in the terminal device. The first apparatus communicates with the second apparatus through an air interface.

Certainly, in embodiments of this application, the first apparatus and the second apparatus may alternatively be devices of another type. For example, the first apparatus may be a device such as a cloud device or a cloud server, and the second apparatus is a device such as a cloud device or a cloud server. This is not limited in this application.

In embodiments of this application, the terminal device may be a device having a wireless transceiver function, and may be specifically user equipment (user equipment, UE), an access terminal, a subscriber unit (subscriber unit), a subscriber station, a mobile station (mobile station), a remote station, a remote terminal, a mobile device, a user terminal, a wireless communication device, a user agent, or a user apparatus. The terminal device may be deployed on land, including an indoor device, an outdoor device, a handheld device, or a vehicle-mounted device; may be deployed on a water surface (for example, on a ship); or may be deployed in the air (for example, on aircraft, a balloon, or a satellite). The terminal device may be a cellular phone, a mobile phone (mobile phone), a tablet computer (pad), a wireless data card, a wireless modem, a satellite terminal, a device mounted on a vehicle (for example, a car, a bicycle, an electric vehicle, an airplane, a ship, a train, or a high-speed railway), a mechanical arm, a workshop device, a wearable device (for example, a smart watch, a smart band, or a pedometer), an uncrewed aerial vehicle, a robot, a smart point of sale (point of sale, POS) machine, customer-premises equipment (customer-premises equipment, CPE), a computer having a wireless transceiver function, a virtual reality (virtual reality, VR) terminal device, an augmented reality (augmented reality, AR) terminal device, a terminal device in industrial control (industrial control), a terminal device in self-driving (self-driving), a terminal device in telemedicine (remote medical), a terminal device in a smart grid (smart grid), a terminal in transportation security (transportation safety), a terminal device in a smart city (smart city), and a terminal (for example, smart home devices such as a refrigerator, a television, an air conditioner, and a meter) in a smart home (smart home). The terminal device may alternatively be another device having a terminal function. A device form of the terminal device is not limited in embodiments of this application. An apparatus configured to implement a function of the terminal device may be a terminal device, or may be an apparatus that can support the terminal device in implementing the function, for example, a chip system. The apparatus may be mounted in the terminal device or used in cooperation with the terminal device. In embodiments of this application, the chip system may include a chip, or may include a chip and another discrete component.

In embodiments of this application, the network device is a device having a wireless transceiver function, and is configured to communicate with the terminal device or another network device. The network device may alternatively be a device, for example, a radio access network (radio access network, RAN) device or a node, that can connect the terminal device to a wireless network. In embodiments of this application, the network device may include various forms of base stations, for example, a base station (base station), an evolved base station (evolved NodeB, eNodeB), a next generation base station (next generation NodeB, gNB), a macro base station, a micro base station (which is also referred to as a small cell), a relay station, an access point, a device that implements a base station function in a communication system evolved after a 5^{th} generation (5^{th} generation, 5G) technology, an access point (access point, AP) in a wireless local area network (wireless local area network, WLAN) system, an integrated access and backhaul (integrated access and backhaul, IAB) node, a transmitting and receiving point (transmitting and receiving point, TRP), a transmission point (transmission point, TP), a mobile switching center, or a device that undertakes a base station function in device-to-device (Device-to-Device, D2D) communication, vehicle-to-everything (vehicle-to-everything, V2X) communication, or machine-to-machine (machine-to-machine, M2M) communication. The network device may further include a network device in a non-terrestrial network (non-terrestrial network, NTN) communication system, in other words, may be deployed on a high-altitude platform or a satellite. In some possible scenarios, different network devices respectively implement a part of functions of the base station. For example, the network device may be a central unit (central unit, CU), a distributed unit (distributed unit, DU), a CU-control plane (control plane, CP), a CU-user plane (user plane, UP), or a radio unit (radio unit, RU). The CU and the DU may be separately disposed, or may be included in a same network element, for example, a baseband unit (baseband unit, BBU). The RU may be included in a radio frequency device or a radio frequency unit, for example, included in a remote radio unit (remote radio unit, RRU), an active antenna unit (active antenna unit, AAU), or a remote radio head (remote radio head, RRH). It may be understood that the network device may be a CU node, a DU node, or a device including a CU node and a DU node. In addition, the CU may be classified as a network device in an access network RAN, or the CU may be classified as a network device in a core network (corenet, CN). This is not limited herein.

In different systems, the CU (or the CU-CP and the CU-UP), the DU, or the RU may also have a different name, but a person skilled in the art may understand a meaning of the name. For example, in an open RAN (open RAN, ORAN) system, the CU may also be referred to as an O-CU (open CU), the DU may also be referred to as an O-DU, the CU-CP may also be referred to as an O-CU-CP, the CU-UP may also be referred to as an O-CU-UP, and the RU may also be referred to as an O-RU. For ease of description, the CU, the CU-CP, the CU-UP, the DU, and the RU are used as examples for description in this application. Any one of the CU (or the CU-CP or the CU-UP), the DU, and the RU in this application may be implemented by using a software module, a hardware module, or a combination of a software module and a hardware module.

Quantization is a process of converting original data into quantized data. The quantization includes scalar quantization (scalar quantization) and vector quantization (vector quantization). The scalar quantization may also be considered as one-dimensional vector quantization, in other words, each piece of original data is quantized individually. The vector quantization is to group original data based on a dimension of d (where d is greater than 1) of quantized data, in other words, each set of data includes d pieces of original data, and then quantization is performed in sequence based on sets.

FIG. 2 is a schematic flowchart of a communication method according to an embodiment of this application. The method includes the following steps.

Step 201: A first apparatus determines a first codebook, where the first codebook is for quantizing first data.

The first codebook includes a quantity (represented by k) of codewords, a dimension (represented by d) of quantized data, and a mapping relationship between the codeword and the quantized data. The quantity of codewords is also referred to as a codebook size, and the dimension of quantized data is also referred to as a codebook dimension. The quantized data mentioned in this application is data obtained through quantization.

In an implementation, the first codebook that is determined by the first apparatus and that corresponds to the first data satisfies a preset modulation and coding scheme (modulation and coding scheme, MCS) requirement. The MCS requirement herein may be determined according to an MCS and based on a transmission resource corresponding to the first data. Specifically, a bit rate may be determined according to the MCS, and then a maximum transmission overhead corresponding to the first data, for example, a maximum quantity of bits that can be transmitted on the transmission resource corresponding to the first data, is determined based on the bit rate and the transmission resource corresponding to the first data. Alternatively, the MCS requirement directly corresponds to a maximum transmission overhead corresponding to the first data. That the first codebook corresponding to the first data satisfies the preset MCS requirement indicates that the transmission resource corresponding to the first data can carry the first codebook and/or the first data is quantized by using the first codebook to obtain quantized data.

FIG. 3 is an example diagram of a scalar quantization manner. In this example, original data in a range of {-1, 1} is mapped to 0, and a corresponding codeword is 00; original data in a range of {1, 3} is mapped to 2, and a corresponding codeword is 01; original data in a range of {3, 5} is mapped to 4, and a corresponding codeword is 10; and original data in a range of {5, 7} is mapped to 6, and a corresponding codeword is 11. Table 1 is an example of a codebook.

**Table 1**

| Codeword (k=4) | Quantized data (d=1) |
|---|---|
| 00 | 0 |
| 01 | 2 |
| 10 | 4 |
| 11 | 6 |

Assuming that the first data includes 0.1, 1.5, 2.8, 5.8, 6.9, and 4.8, if the first apparatus determines that the first codebook corresponding to the first data is shown in Table 1, after the first data is mapped to quantized data, a codeword corresponding to each piece of quantized data is determined by using the codebook shown in Table 1. Finally, the first apparatus sends the codewords instead of the first data to a second apparatus. Specifically, according to the examples in FIG. 3 and Table 1, 0.1 is mapped to 0, and a corresponding codeword is 00; 1.5 is mapped to 2, and a corresponding codeword is 01; 2.8 is mapped to 2, and a corresponding codeword is 01; 5.8 is mapped to 6, and a corresponding codeword is 11; 6.9 is mapped to 6, and a corresponding codeword is 11; and 4.8 is mapped to 4, and a corresponding codeword is 10.

If the first apparatus sends the first data to the second apparatus, each piece of data generally occupies 32 bits to ensure accuracy of data expression, so that transmission of 0.1, 1.5, 2.8, 5.8, 6.9 and 4.8 needs a total of 32*6=192 bits.

If the foregoing quantization manner is used, the codewords sent by the first apparatus to the second apparatus include 00, 01, 01, 11, 11, and 10, and occupy a total of 2*6=12 bits. Therefore, compared with a manner of directly sending the first data, the manner of sending the codewords corresponding to the quantized data can reduce transmission overheads.

After receiving the codewords sent by the first apparatus, the second apparatus may map the received codewords to quantized data based on the first codebook. To be specific, the second apparatus determines that the quantized data corresponding to the first data includes 0, 2, 2, 6, 6, and 4. In this quantization manner, data accuracy is lowered, but data transmission overheads can be reduced.

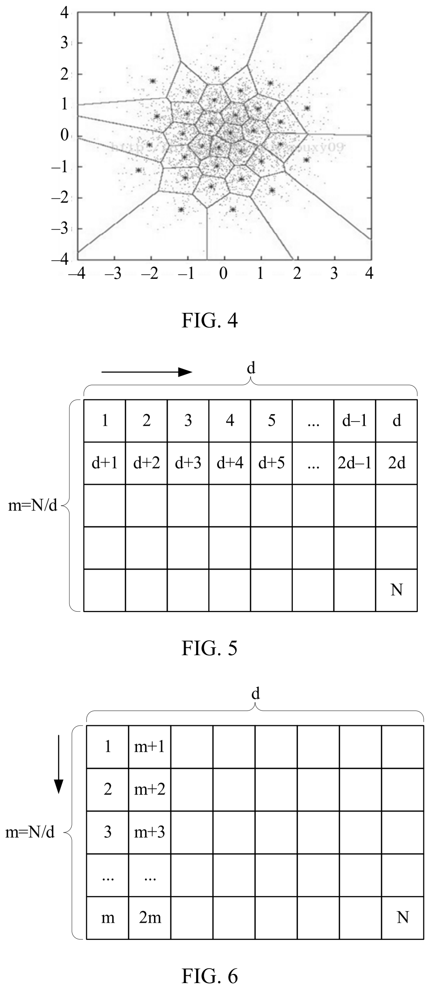

In vector quantization, it is assumed that a quantity of codewords included in a codebook is k, and a dimension of each codeword is d. Each set of data is mapped to one of the k codewords. For example, 1^{st} to 10^{th} sets of data are mapped to a codeword 1, and 11^{th} to 20^{th} sets of data are mapped to a codeword 2. A quantity of bits that need to be occupied by the k codewords is log2(k), so that the log2(k) bits may represent one set of data. FIG. 4 is an example diagram of two-dimensional vector quantization. Original data is grouped based on the dimension d=2, to obtain a plurality of pieces of two-dimensional data. Each piece of two-dimensional data includes two pieces of original data. Each black point in FIG. 4 represents one piece of two-dimensional data, and each star point in FIG. 4 represents one codeword. There are a total of k codewords (that is, k star points). According to a quantization algorithm, a region formed by the plurality of pieces of two-dimensional data (that is, all black points in FIG. 4) may be divided into a plurality of subregions. Two-dimensional data in each sub-region is mapped to a same codeword. Refer to FIG. 4. All black points in each sub-region are mapped to star points in the sub-region. Table 2 is another example of a codebook. In this example, k=256, each codeword occupies 8 bits, and d=16, to be specific, every 16 pieces of original data are grouped into one set.

**Table 2**

| Codeword (k=256) | Quantized data (d=16) |
|---|---|
| 00000000 | 1.2, 1.5, 1.2, 1.3, 2.1, ..., 2.3, 3.0, and 1.5 |
| 00000001 | 1.3, 1.8, 1.9, 1.7, 2.5, ..., 2.9, 1.0, and 1.6 |
| ... | ... |
| 11111111 | 1.7, 1.9, 2.2, 1.6, 2.5, ..., 2.5, 3.2, and 1.3 |

The first data is grouped based on every 16 pieces of data, to obtain a plurality of sets of data. If the first apparatus determines that the first codebook corresponding to the first data is shown in Table 2, after the first data is mapped to quantized data, where each piece of quantized data is one set of data including 16 pieces of original data, a codeword corresponding to each piece of the quantized data is determined by using the codebook shown in Table 2. Finally, a plurality of codewords are sent to the second apparatus, and each codeword occupies 8 bits.

An example in which the first data includes 1,600 pieces of original data is used. If the first apparatus sends the first data to the second apparatus, each piece of data generally occupies 32 bits to ensure accuracy of data expression, so that transmission of the 1,600 pieces of original data needs a total of 32*1,600=51,200 bits.

If the foregoing quantization manner is used, the 1,600 pieces of original data are divided into 100 sets, and each set of data includes 16 pieces of original data. Then, quantized data corresponding to each set of data is determined, and 100 pieces of quantized data are obtained. In addition, a codeword corresponding to each piece of quantized data is determined. In this case, the codewords sent by the first apparatus to the second apparatus occupy a total of 8*100=800 bits. Therefore, compared with a manner of directly sending the first data, the manner of sending the codewords corresponding to the quantized data can reduce transmission overheads.

After receiving the codewords sent by the first apparatus, the second apparatus may map the received codewords to quantized data based on the first codebook. In this quantization manner, data accuracy is lowered, but data transmission overheads can be reduced.

The following describes two different grouping methods for the vector quantization. It is assumed that a quantity of original data in the first data is N, and a dimension of the quantized data is d.

Method 1: The N pieces of original data in the first data are sequentially divided into m sets based on the dimension d of the quantized data, where m=N/d, and each set includes d pieces of original data.

FIG. 5 is an example diagram of a grouping manner. It can be learned that a 1^{st} set of data includes 1^{st} to d^{th} pieces of original data in the first data; a 2nd set of data includes (d+1)^{th} to (2d)^{th} pieces of original data in the first data; and so on.

Method 2: The N pieces of original data in the first data are divided into m sets in an interleaving manner based on the dimension d of the quantized data, where each set includes d pieces of original data, and an interleaving depth is m=N/d.

FIG. 6 is an example diagram of another grouping manner. Data is read in by column and read out by row. Through interleaving, distribution of original data may be transformed, so that a distribution feature needed by the vector quantization may be obtained. Specifically, compared with that of the scalar quantization, a gain source of the vector quantization mainly depends on a distribution feature of data. When distribution of data is concentrated, the vector quantization may achieve low transmission overheads. It can be learned that a 1^{st} set of data includes a 1^{st} piece of original data, an (m+1)^{th} piece of original data, a (2m+1)^{th} piece of original data, ..., and a ((d-1)m+1)^{th} piece of original data in the first data; and a 2^{nd} set of data includes a 2^{nd} piece of original data, an (m+2)^{th} piece of original data, a (2m+2)^{th} piece of original data, ..., and a ((d-1)m+2)^{th} piece of original data in the first data; and so on.

For the foregoing method 1 and method 2, when the original data in the first data is grouped, and N is not an integer multiple of d, either of the following processing manners may be used.

Processing manner 1: The first apparatus discards a last set of data, and a quantity of original data in the set of data is less than d. The second apparatus automatically pads, based on the quantity N of original data in the first data and the dimension d of the quantized data, with a corresponding quantity of preset values, for example, pads with zeros.

Processing manner 2: The first apparatus pads a last set of data with a corresponding quantity of preset values, for example, pads with zeros, so that a quantity of original data in the set of data is equal to d. The second apparatus deletes redundant data from the last set of data based on the quantity N of original data in the first data and the dimension d of the quantized data.

Step 202: The first apparatus sends first indication information to the second apparatus. Correspondingly, the second apparatus receives the first indication information.

The first indication information indicates the first codebook.

In an implementation, if there are a plurality of codebooks and indexes of the codebooks on the first apparatus, or there are a plurality of codebooks and indexes of the codebooks on the first apparatus and the second apparatus, when the first codebook is one of the plurality of codebooks, the first indication information may be an index of the first codebook. For example, the plurality of codebooks and the indexes of the codebooks on the first apparatus and the second apparatus may be predefined in a protocol, or may be preconfigured. This is not limited in this application.

In another implementation, the first indication information includes the first codebook, to be specific, the first indication information includes the quantity of codewords, the dimension of the quantized data, and the mapping relationship, where the mapping relationship is a mapping relationship between the codeword and the quantized data. For example, the first codebook may be shown in Table 1 or Table 2.

Step 203: The second apparatus determines the first codebook based on the first indication information.

In an implementation, the first indication information is the index of the first codebook. In this case, the second apparatus obtains, based on the index, the first codebook from the plurality of codebooks predefined or preconfigured on the second apparatus.

In another implementation, the first indication information includes the first codebook. In this case, the second apparatus obtains the first codebook from the first indication information.

In the foregoing solution, the first data is quantized by using the codebook, so that transmission resource overheads during data transmission can be reduced.

In an implementation, the first apparatus further quantizes the first data to obtain the quantized data, then determines, based on the first codebook, a codeword corresponding to the quantized data, and sends the codeword corresponding to the quantized data to the second apparatus. The codeword corresponding to the quantized data and the first indication information may be sent together, or may be sent separately. After receiving the codeword corresponding to the quantized data, the second apparatus determines the quantized data based on the first codebook and the codeword corresponding to the quantized data. To be specific, the second apparatus maps the received codeword to quantized data by using the first codebook. The obtained quantized data is the quantized data corresponding to the first data.

In an implementation, the first data is associated with a first service. To be specific, the first data is data of the first service.

In an implementation, the first data is associated with a first data radio bearer. To be specific, the codeword corresponding to the quantized data of the first data is sent to the second apparatus through the first data radio bearer.

In an implementation, the first data is associated with a first logical channel. To be specific, the codeword corresponding to the quantized data of the first data is sent to the second apparatus through the first logical channel.

In an implementation, in step 201, that the first apparatus determines the first codebook corresponding to the first data may be specifically: The first apparatus determines a first codebook set based on a distribution feature of the first data, where the first codebook set includes at least one codebook, and then the first apparatus determines the first codebook in the first codebook set, to be specific, selects the first codebook from the first codebook set. In the method, a codebook set is first determined, and then the first codebook corresponding to the first data is selected from the codebook set. This helps accurately determine the first codebook corresponding to the first data.

In an implementation, a quantization error of the codebook in the first codebook set is less than or equal to a quantization error threshold, and the quantization error threshold is preconfigured or predefined. For example, the quantization error threshold is related to an importance degree (such as a packet loss rate or a delay) of the first data. For example, when the packet loss rate corresponding to the first data is less than a first threshold, the quantization error threshold is less than a second threshold. When the packet loss rate corresponding to the first data is less than a third threshold, the quantization error threshold is less than a fourth threshold. The third threshold is less than the first threshold, and the fourth threshold is less than the second threshold.

In an implementation, that the first apparatus determines the first codebook set based on the distribution feature of the first data specifically includes: The first apparatus determines, based on the distribution feature of the first data and a mapping relationship between the distribution feature and a codebook, the first codebook set that is in the mapping relationship and that corresponds to the distribution feature of the first data. The mapping relationship is preconfigured or predefined. In the method, the first codebook corresponding to the first data is determined based on the preconfigured or predefined mapping relationship, so that the first codebook can be quickly determined.

The distribution feature of the first data includes a data distribution slope (represented by *ρ*) of the first data and/or a data expectation (represented by *ε*) of the first data. The data distribution slope may be a cumulative distribution function (cumulative distribution function, CDF) distribution slope (represented by *ρ_{CDF}*) or a probability density function (probability density function, PDF) distribution slope (represented by *ρ_{PDF}*).

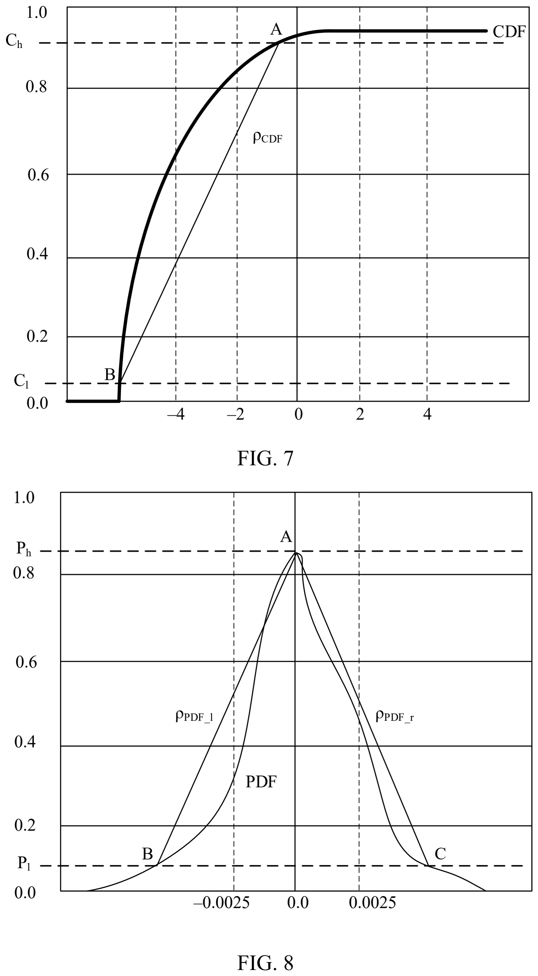

FIG. 7 is a diagram of a CDF distribution slope. In the figure, a point A is an intersection point of a highest reference probability *Cₕ* and a CDF curve of the first data, and a point B is an intersection point of a lowest reference probability *Cₗ* and the CDF curve of the first data. The point A and the point B are connected to obtain a CDF distribution slope, that is, *ρ_{CDF},* of the first data. *Cₕ* is a number close to 1, and *Cₗ* is a number close to 0.

FIG. 8 is a diagram of a PDF distribution slope. In the figure, a point A is a highest absolute probability *Pₕ* and is a peak value of a PDF curve of the first data, a point B is a 1^{st} intersection point of a lowest reference probability *Pₗ* and the PDF curve of the first data, and a point C is a last intersection point of the lowest reference probability *Pₗ* and the PDF curve of the first data. The point A and the point B are connected to obtain a 1^{st} CDF distribution slope, that is, *ρ_{PDF_l},* of the first data. The point A and the point C are connected to obtain a 2^{nd} CDF distribution slope, that is, *ρ_{PDF_r},* of the first data. *Pₗ* is a number close to 0. A PDF distribution slope of the first data satisfies that *ρ_{PDF}* = min (|*ρ_{PDF_l}*|, |*ρ_{PDF_r}*|). To be specific, a smaller one of an absolute value of *ρ_{PDF_r}* and an absolute value of *ρ_{PDF_l}* is used as the CDF distribution slope of the first data.

The distribution feature of the first data affects quantization performance, and the quantization performance may be specifically measured based on a quantization error, a data loss rate, and data accuracy. The following uses the quantization error as an example to describe specific impact of the distribution feature of the first data on the quantization performance. In the case of a given distribution slope p, a higher codeword dimension d indicates a larger slope of a quantization error curve. In the case of a same codeword dimension d, a larger codebook indicates a smaller quantization error. Table 3 shows a correspondence between a distribution slope p, a codeword dimension d, and a codebook size k when a quantization error of a codebook is less than a quantization error threshold of 0.02.

**Table 3**

| Distribution slope (ρ1 < ρ2 < ρ3) | Codeword dimension d | Codebook size k of the codebook whose quantization error is less than the quantization error threshold of 0.02 |
|---|---|---|
| ρ1 | 2 | 32, 64, 128, 256, and 512 |
| | 4 | 256 and 512 |
| | 8 | \ |
| | 16 | \ |
| | 32 | \ |
| ρ2 | 2 | 16, 32, 64, 128, 256, and 512 |
| | 4 | 64, 128, 256, and 512 |
| | 8 | 256 and 512 |
| | 16 | 512 |
| | 32 | 256 and 512 |
| ρ3 | 2 | 8, 16, 32, 64, 128, 256, and 512 |
| | 4 | 32, 64, 128, 256, and 512 |
| | 8 | 128, 256, and 512 |
| | 16 | 128, 256, and 512 |
| | 32 | 128, 256, and 512 |

It can be learned from Table 3 that, in consideration of quantization performance, when the distribution slope is small, a small codeword dimension is first lower than a specific quantization error threshold; as the distribution slope increases, a large codeword dimension is also lower than the specific quantization error threshold; and when the distribution slope is large, a medium-size codeword dimension is finally lower than the specific quantization error threshold. In other words, for a codeword dimension satisfying specific quantization performance, a trend of a small codeword dimension and a large codeword dimension at both ends and a medium-size codeword dimension in the middle is presented as the distribution slope increases.

For example, Table 4 shows a codeword dimension d corresponding to a distribution slope p in different value ranges.

**Table 4**

| Distribution slope p | Codeword dimension d |
|---|---|
| p ≤ 0.1 | 2 |
| 0.1<ρ ≤ 0.5 | 2 and 4 |
| *0.5<*ρ ≤ 0.7 | 2, 4, and 32 |
| *0.7<*ρ ≤ 0.9 | 2, 4, 8, and 32 |
| 0.9<*ρ* | 2, 4, 8, 16, and 32 |

It can be learned from Table 4 that, a larger distribution slope of the first data, in other words, data being distributed concentratedly and specific quantization performance being achieved (to be specific, lower than a specific quantization error), indicates more codeword dimensions that may be used; and a smaller distribution slope of the first data, in other words, data being distributed dispersedly and specific quantization performance being achieved (to be specific, lower than a specific quantization error), indicates fewer codeword dimensions that may be used.

For example, Table 5 provides a correspondence between a distribution slope *p,* a codeword dimension d, a data expectation *ε*, a codebook size k (that is, a quantity of codewords in a codebook), and a codebook. In addition, all codebooks in Table 5 satisfy a specific quantization error. For example, the quantization error is less than or equal to the quantization error threshold of 0.02. In Table 5, an example in which *ρ* ≤ 0.1 is used, and there is also a similar table for other values of *p.*

**Table 5**

| Distribution slope *ρ* | Codeword dimension d | Data expectation *ε* | Codebook size k | Codebook |
|---|---|---|---|---|
| *ρ* ≤ 0.1 | 2 | *ε*1 | 2 | Codebook 1 |
| | | | 4 | Codebook 2 |
| | | | 8 | Codebook 3 |
| | | | 16 | Codebook 4 |
| | | *ε*2 | 2 | Codebook 5 |
| | | | 4 | Codebook 6 |
| | | | 8 | Codebook 7 |
| | | | 16 | Codebook 8 |
| | | | 32 | Codebook 9 |

Refer to Table 5. When the distribution slope of the first data satisfies that *p* ≤ 0.1, a dimension d of a codeword corresponding to the first data is equal to 2. In addition, when data expectations of the first data are respectively *ε*1 and *ε*2, corresponding codebooks may be selected.

For example, assuming that the distribution slope of the first data satisfies that *ρ* ≤ 0.1 and the data expectation is *ε*1, the first codebook set corresponding to the first data includes the codebook 1, the codebook 2, the codebook 3, and the codebook 4. Optionally, a quantization error of the codebook in the first codebook set is less than or equal to the quantization error threshold.

The following describes three different implementations for the first apparatus to determine the first codebook in the first codebook set.

In a first implementation, that the first apparatus determines the first codebook in the first codebook set is specifically: The first apparatus determines the first codebook based on a transmission overhead corresponding to the codebook in the first codebook set. For example, a codebook having a minimum transmission overhead is selected from the first codebook set as the first codebook corresponding to the first data. The transmission overhead corresponding to the codebook includes a codebook indication overhead and/or a data transmission overhead for quantized first data.

The codebook indication overhead is an indication overhead for the first apparatus to indicate the selected first codebook to the second apparatus. If the first indication information sent by the first apparatus in step 202 is the index of the first codebook, the codebook indication overhead is a quantity of bits occupied by the index of the first codebook. If the first indication information sent by the first apparatus in step 202 includes the first codebook, the codebook indication overhead is equal to k*d*32. k represents a quantity of codewords in the first codebook, d represents a codeword dimension of each codeword (that is, a dimension of quantized data), and 32 represents a quantity of bits occupied by each piece of data in the quantized data. Table 1 is used as an example. If k=4 and d=1, the codebook indication overhead is equal to 128 bits. Table 2 is used as an example. If k=128 and d=16, the codebook indication overhead is equal to 65,536 bits.

The data transmission overhead for quantized first data is a transmission overhead of a codeword corresponding to the quantized data obtained by quantizing the first data. The transmission overhead of the codeword is equal to (N/d)*log2(k). N represents a quantity of original data in the first data, and d represents a dimension of the quantized data (that is, a dimension of a codeword). In this case, N/d represents a quantity of quantized data, that is, a quantity of codewords that need to be used. k represents a quantity of codewords in the first codebook. log2(k) represents a quantity of bits occupied by each codeword. Table 1 is used as an example. Assuming that k=4 and d=1, if N=1,600, the data transmission overhead for quantized first data is equal to 3,200 bits. Table 2 is used as an example. Assuming that k=256 and d=16, if N=1,600, the data transmission overhead for quantized first data is equal to 800 bits.

In a second implementation, that the first apparatus determines the first codebook in the first codebook set is specifically: The first apparatus sends first information to the second apparatus, where the first information indicates a part or all of codebooks in the first codebook set. For example, the first information includes transmission overheads corresponding to the part or all of the codebooks in the first codebook set, and the transmission overhead includes a codebook indication overhead and/or a data transmission overhead for quantized first data. For another example, the first information includes indexes of the part or all of the codebooks in the first codebook set. In other words, content actually included in the first information is the transmission overheads corresponding to the part or all of the codebooks in the first codebook set or the indexes of the codebooks, and the transmission overheads corresponding to the part or all of the codebooks in the first codebook set or the indexes of the codebooks indicate the part or all of the codebooks in the first codebook set. Optionally, the transmission overhead corresponding to the codebook indicated by the first information is less than a transmission overhead threshold. To be specific, the first apparatus selects, from the first codebook set, a codebook whose transmission overhead is less than the transmission overhead threshold, and indicates the selected codebook based on the first information. After receiving the first information, the second apparatus determines whether to use (utilize or adopt) the codebook indicated by the first information, and then the second apparatus sends second information to the first apparatus, where the second information indicates that a part or all of the codebooks indicated by the first information are used (utilized or adopted). The first apparatus determines the first codebook based on the second information. For example, the first apparatus may select a codebook that corresponds to a minimum transmission overhead and that is in the codebooks indicated by the second information, or select a codebook that corresponds to a minimum quantization error and that is in the codebooks indicated by the second information.

The following provides descriptions with reference to examples. For example, the first codebook set includes a codebook 1, a codebook 2, a codebook 3, and a codebook 4. Transmission overheads corresponding to the codebook 1, the codebook 2, and the codebook 3 are all less than the transmission overhead threshold, and a transmission overhead corresponding to the codebook 4 is greater than the transmission overhead threshold.

In an example, the first information sent by the first apparatus to the second apparatus includes a transmission overhead 1 corresponding to the codebook 1, a transmission overhead 2 corresponding to the codebook 2, and a transmission overhead 3 corresponding to the codebook 3. If the second apparatus determines that the transmission overhead 1 and the transmission overhead 2 are allowed, and the transmission overhead 3 is not allowed, the second apparatus sends the second information to the first apparatus, where the second information includes the transmission overhead 1 corresponding to the codebook 1 and the transmission overhead 2 corresponding to the codebook 2, and does not include the transmission overhead 3 corresponding to the codebook 3. After receiving the second information, the first apparatus determines that codebooks that are indicated by the second information and that are allowed by the second apparatus to be used include the codebook 1 and the codebook 2, and then the first apparatus selects one codebook, that is, the first codebook, from the codebook 1 and the codebook 2.

In another example, the first information sent by the first apparatus to the second apparatus includes a transmission overhead 1 corresponding to the codebook 1, a transmission overhead 2 corresponding to the codebook 2, and a transmission overhead 3 corresponding to the codebook 3. If the second apparatus determines that none of the transmission overhead 1, the transmission overhead 2, and the transmission overhead 3 is allowed, the second apparatus sends indication information to the first apparatus, where the indication information indicates that none of the transmission overheads corresponding to the codebooks indicated by the first information is allowed. The first apparatus receives the indication information and determines that the codebooks cannot be selected, in other words, the first codebook corresponding to the first data cannot be selected. Then, the first apparatus may adjust the MCS requirement and/or the quantization error threshold, re-determine a first codebook set, and then re-determine the first codebook according to the foregoing method.

In another example, the first information sent by the first apparatus to the second apparatus includes an index 1 of the codebook 1, an index 2 of the codebook 2, and an index 3 of the codebook 3. If the second apparatus determines that the codebook 1 and the codebook 2 are allowed to be used, and the codebook 3 is not allowed to be used, the second apparatus sends the second information to the first apparatus, where the second information includes the index 1 of the codebook 1 and the index 2 of the codebook 2, and does not include the index 3 of the codebook 3. After receiving the second information, the first apparatus determines that codebooks that are indicated by the second information and that are allowed by the second apparatus to be used include the codebook 1 and the codebook 2, and then the first apparatus selects one codebook, that is, the first codebook, from the codebook 1 and the codebook 2.

In another example, the first information sent by the first apparatus to the second apparatus includes an index 1 of the codebook 1, an index 2 of the codebook 2, and an index 3 of the codebook 3. If the second apparatus determines that none of the codebook 1, the codebook 2, and the codebook 3 is allowed, the second apparatus sends indication information to the first apparatus, where the indication information indicates that none of the codebooks indicated by the first information is allowed. The first apparatus receives the indication information and determines that the codebooks cannot be selected, in other words, the first codebook corresponding to the first data cannot be selected. Then, the first apparatus may adjust the MCS requirement and/or the quantization error threshold, re-determine a first codebook set, and then re-determine the first codebook according to the foregoing method.

In a third implementation, that the first apparatus determines the first codebook in the first codebook set is specifically: The first apparatus receives third information from the second apparatus, where the third information indicates the first codebook in the first codebook set. In other words, the second apparatus selects the first codebook from the first codebook set, and indicates the first codebook to the first apparatus. Certainly, the second apparatus may not select the first codebook from the first codebook set. Instead, the second apparatus autonomously determines the first codebook corresponding to the first data and indicates the first codebook to the first apparatus.

In an implementation, the following step 204 to step 206 may be further performed, and an execution sequence of step 204 to step 206 and the foregoing step 201 to step 203 is not limited.

Step 204: The first apparatus determines a second codebook, where the second codebook is for quantizing second data.

The second codebook includes a quantity of codewords, a dimension of quantized data, and a mapping relationship between the codeword and the quantized data. The quantity of codewords is also referred to as a codebook size.

A manner of determining the second codebook is similar to the foregoing manner of determining the first codebook. For details, refer to the foregoing descriptions.

In an implementation, the second codebook is the same as the first codebook. To be specific, the quantity of codewords in the second codebook is the same as the quantity of codewords in the first codebook, the dimension of the quantized data in the second codebook is the same as the dimension of the quantized data in the first codebook, and the mapping relationship between the codeword and the quantized data in the second codebook is the same as the mapping relationship between the codeword and the quantized data in the first codebook.

In another implementation, the second codebook is different from the foregoing first codebook. To be specific, at least one of the following conditions is satisfied.

(1) The quantity of codewords in the second codebook is different from the quantity of codewords in the first codebook.

(2) The dimension of the quantized data in the second codebook is different from the dimension of the quantized data in the first codebook.

(3) The mapping relationship between the codeword and the quantized data in the second codebook is different from the mapping relationship between the codeword and the quantized data in the first codebook.

The second data is different from the foregoing first data.

In an implementation, if embodiments of this application are applied to a data transmission scenario for an artificial intelligence (artificial intelligence, AI) model, data of the artificial intelligence model may be divided into a plurality of pieces of data, and each piece of data corresponds to one codebook. The plurality of pieces of data include the first data and the second data. Therefore, the first data and the second data correspond to a same artificial intelligence model. A specific type of the AI model is not limited in this application. For example, the AI model includes one or more of a logistic regression (logistic regression) model, a decision tree (decision tree) model, a support vector machine (support vector machine, SVM) model, a random forest (random forest) model, a neural network (neural network) model, a convolutional neural network (convolutional neural network, CNN) model, a recurrent neural network (recurrent neural network, RNN) model, a regression neural network (regression neutral network, RNN) model, a deep neural network (dense neutral network, DNN) model, or a generative adversarial network (generative adversarial network, GAN) model.

The following describes different implementations of dividing the data of the artificial intelligence model into the plurality of pieces of data.

Implementation 1: One layer in the artificial intelligence model is divided into one piece of data.

For example, the first data or the second data is data of one layer in the artificial intelligence model.

A specific type of the layer in the AI model is not limited in this application. For example, the layer in the AI model includes but is not limited to one or more of a convolution layer, a pooling layer, a full connection (full connection, FC) layer, an impact function layer, or a batch normalization (batch normalization, BN) layer.

Implementation 2: A plurality of layers in the artificial intelligence model are divided into one piece of data.

For example, the first data or the second data is data of the plurality of layers in the artificial intelligence model.

For example, a plurality of layers that have a same structure and that consecutively appear in the artificial intelligence model may be divided into one layer group, and data of the layer group is divided into one piece of data.

Implementation 3: Data of one layer in the artificial intelligence model is divided into a plurality of data sets, and data in each data set is divided into one piece of data.

For example, data of a layer in the artificial intelligence model is divided into three data sets, data in the three data sets is divided into three pieces of data, and each of the three pieces of data corresponds to one codebook. For example, the first data is a 1^{st} piece of data in the three pieces of data, and the second data is a 2^{nd} piece of data in the three pieces of data.

Step 205: The first apparatus sends second indication information to the second apparatus. Correspondingly, the second apparatus receives the second indication information.

The second indication information indicates the second codebook.

In an implementation, if there are a plurality of codebooks and indexes of the codebooks predefined or preconfigured on the first apparatus, or there are a plurality of codebooks and indexes of the codebooks predefined or preconfigured on the first apparatus and the second apparatus, when the second codebook is one of the plurality of codebooks, the second indication information may be an index of the second codebook.

In another implementation, the second indication information includes the second codebook, to be specific, the second indication information includes the quantity of codewords, the dimension of the quantized data, and the mapping relationship between the codeword and the quantized data. For example, the second codebook may be shown in Table 1 or Table 2.

Step 206: The second apparatus determines the second codebook based on the second indication information.

In an implementation, the second indication information is the index of the second codebook. In this case, the second apparatus obtains, based on the index, the second codebook from the plurality of codebooks predefined or preconfigured on the second apparatus.

In another implementation, the second indication information includes the second codebook. In this case, the second apparatus obtains the second codebook from the second indication information.

In the foregoing solution, the second data is quantized by using the codebook, so that transmission resource overheads during data transmission can be reduced.

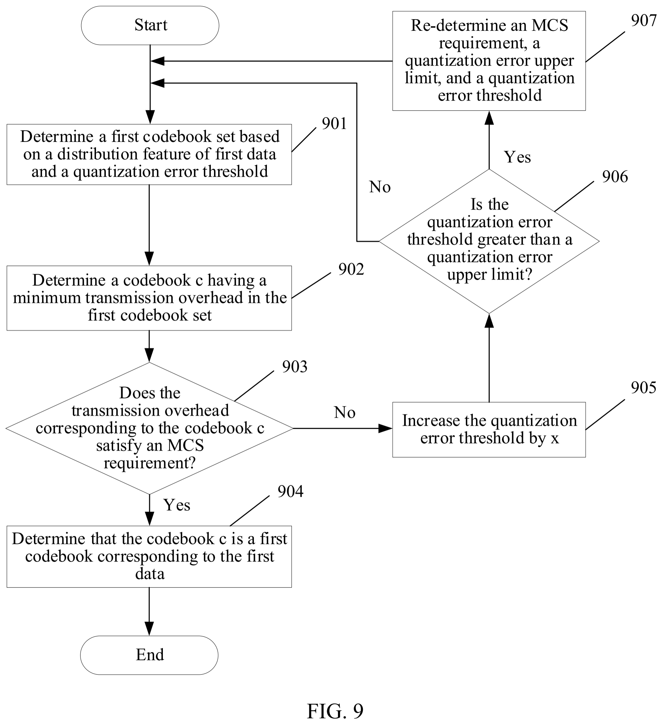

FIG. 9 is a schematic flowchart of another communication method according to an embodiment of this application. The method is a specific implementation of determining the first codebook corresponding to the first data in the embodiment in FIG. 2. In the method, a first apparatus autonomously determines a first codebook corresponding to first data. For example, the method is applicable to a scenario in which a terminal device in a sidelink autonomously determines a transmission resource, or is applicable to a downlink transmission scenario.

The method includes the following steps.

Step 901: The first apparatus determines a first codebook set based on a distribution feature of the first data and a quantization error threshold.

All codebooks in the first codebook set are less than the quantization error threshold.

For a specific implementation of determining the first codebook set based on the distribution feature of the first data and the quantization error threshold, refer to the descriptions of the embodiment in FIG. 2.

Step 902: The first apparatus determines a codebook c having a minimum transmission overhead in the first codebook set.

For a manner of determining a transmission overhead of a codebook in the first codebook set, refer to the descriptions in the embodiment in FIG. 2.

Step 903: The first apparatus determines whether the transmission overhead corresponding to the codebook c satisfies an MCS requirement.

If the MCS requirement is satisfied, step 904 is performed. If the MCS requirement is not satisfied, step 905 is performed.

Step 904: The first apparatus determines that the codebook c is the first codebook corresponding to the first data.

In other words, transmission is subsequently performed on quantized data of the first data by using the codebook c.

Step 905: The first apparatus increases the quantization error threshold by x.

Because the transmission overhead corresponding to the codebook c does not satisfy the MCS requirement, the first apparatus increases the quantization error threshold by a value of x. This helps the first apparatus determine, in a next cycle process, a codebook that satisfies the MCS requirement.

Step 906: The first apparatus determines whether the quantization error threshold is greater than a quantization error upper limit.

If an adjusted quantization error threshold is greater than the quantization error upper limit, step 907 is performed. If an adjusted quantization error threshold is less than or equal to the quantization error upper limit, step 901 is performed.

Step 907: The first apparatus re-determines an MCS requirement, a quantization error upper limit, and a quantization error threshold.

Because the quantization error threshold has exceeded the quantization error upper limit, the first apparatus needs to reset the MCS requirement, the quantization error upper limit, and the quantization error threshold, to re-perform a process of determining a codebook corresponding to the first data. After step 907 is performed, step 901 is performed.

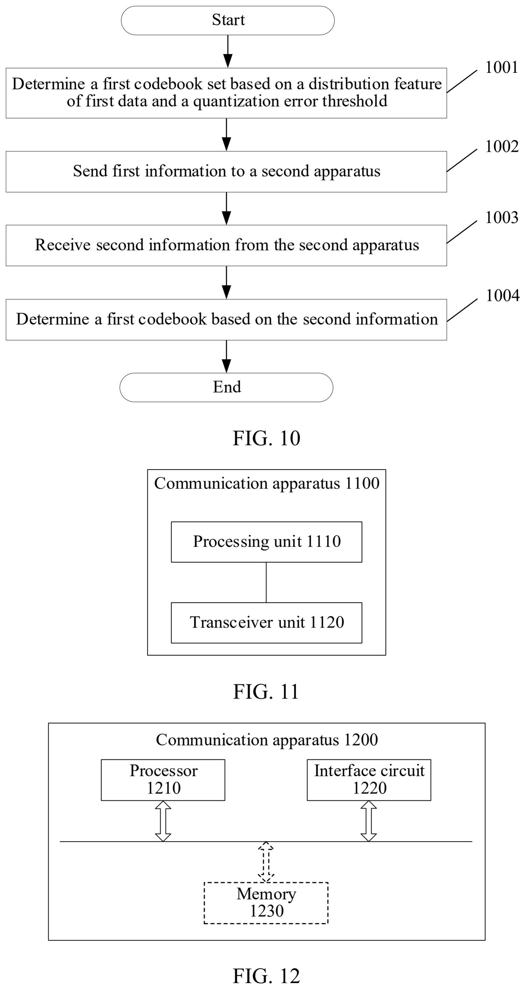

FIG. 10 is a schematic flowchart of another communication method according to an embodiment of this application. The method is a specific implementation of determining the first codebook corresponding to the first data in the embodiment in FIG. 2. In the method, a first apparatus and a second apparatus jointly determine a first codebook corresponding to first data. For example, the method is applicable to an uplink transmission scenario. The method includes the following steps.

Step 1001: The first apparatus determines a first codebook set based on a distribution feature of the first data and a quantization error threshold.

All codebooks in the first codebook set are less than the quantization error threshold.

For a specific implementation of determining the first codebook set based on the distribution feature of the first data and the quantization error threshold, refer to the descriptions of the embodiment in FIG. 2.

Step 1002: The first apparatus sends first information to the second apparatus.

The first information indicates a part or all of the codebooks in the first codebook set. For example, the first information indicates a codebook that is in the first codebook set and whose transmission overhead is less than a transmission overhead threshold.

The first information includes transmission overheads corresponding to the part or all of the codebooks in the first codebook set, and the transmission overhead includes a codebook indication overhead and/or a data transmission overhead for quantized first data.

Alternatively, the first information includes indexes of the part or all of the codebooks in the first codebook set.

For a specific implementation of the first information, refer to the descriptions of the embodiment in FIG. 2.

Step 1003: The first apparatus receives second information from the second apparatus.

The second information indicates that a part or all of the codebooks indicated by the first information are used (utilized or adopted).

For a specific implementation of the second information, refer to the descriptions of the embodiment in FIG. 2.

Step 1004: The first apparatus determines the first codebook based on the second information.

For example, the first apparatus selects a codebook that corresponds to a minimum transmission overhead and that is in the codebooks indicated by the second information, or selects a codebook that corresponds to a minimum quantization error and that is in the codebooks indicated by the second information.

It may be understood that, to implement the functions in the foregoing embodiments, the first apparatus or the second apparatus includes corresponding hardware structures and/or software modules for performing the functions. A person skilled in the art should be easily aware that, in this application, the units and method steps in the examples described with reference to embodiments disclosed in this application can be implemented by hardware or a combination of hardware and computer software. Whether a function is performed by hardware or hardware driven by computer software depends on particular application scenarios and design constraint conditions of the technical solutions.

FIG. 11 and FIG. 12 are diagrams of structures of possible communication apparatuses according to embodiments of this application. These communication apparatuses may be configured to implement the functions of the first apparatus or the second apparatus in the foregoing method embodiments, and therefore can also achieve the beneficial effects of the foregoing method embodiments. In embodiments of this application, the communication apparatus may be the first apparatus or the second apparatus shown in FIG. 1.

As shown in FIG. 11, the communication apparatus 1100 includes a processing unit 1110 and a transceiver unit 1120. The communication apparatus 1100 is configured to implement the functions of the first apparatus or the second apparatus in the foregoing method embodiments.

When the communication apparatus 1100 is configured to implement a function of the first apparatus in the foregoing method embodiment, the processing unit 1110 is configured to determine a first codebook, where the first codebook is for quantizing first data; and the transceiver unit 1120 is configured to send first indication information, where the first indication information indicates the first codebook.

In a possible implementation, that the processing unit 1110 is configured to determine the first codebook specifically includes: The processing unit 1110 is configured to: determine a first codebook set based on a distribution feature of the first data, where the first codebook set includes at least one codebook; and determine the first codebook in the first codebook set.

In a possible implementation, that the processing unit 1110 is configured to determine the first codebook in the first codebook set specifically includes: The processing unit 1110 is configured to determine the first codebook based on a transmission overhead corresponding to a codebook in the first codebook set.

In a possible implementation, the transmission overhead includes a codebook indication overhead and/or a data transmission overhead for quantized first data.

In a possible implementation, that the processing unit 1110 is configured to determine the first codebook in the first codebook set specifically includes: The processing unit 1110 is configured to: send first information by using the transceiver unit 1120, where the first information indicates a part or all of codebooks in the first codebook set; receive second information by using the transceiver unit 1120, where the second information indicates that a part or all of the codebooks indicated by the first information are used; and determine the first codebook based on the second information.

In a possible implementation, a transmission overhead corresponding to the codebook indicated by the first information is less than a transmission overhead threshold.

In a possible implementation, that the processing unit 1110 is configured to determine the first codebook in the first codebook set specifically includes: The processing unit 1110 is configured to receive third information by using the transceiver unit 1120, where the third information indicates the first codebook.

In a possible implementation, a quantization error of the codebook in the first codebook set is less than or equal to a quantization error threshold.

In a possible implementation, the quantization error threshold is preconfigured or predefined.

In a possible implementation, the quantization error threshold is related to an importance degree of the first data.

In a possible implementation, that the processing unit 1110 is configured to determine the first codebook set based on the distribution feature of the first data specifically includes: The processing unit 1110 is configured to determine, based on the distribution feature of the first data and a mapping relationship between the distribution feature and a codebook, the first codebook set that is in the mapping relationship and that corresponds to the distribution feature of the first data.

In a possible implementation, the distribution feature of the first data includes a data distribution slope and/or a data expectation.

In a possible implementation, the first codebook satisfies a preset modulation and coding scheme MCS requirement.

In a possible implementation, the first data is associated with a first service, a first data radio bearer, or a first logical channel.

In a possible implementation, the processing unit 1110 is further configured to: quantize the first data to obtain quantized data; and determine, based on the first codebook, a codeword corresponding to the quantized data; and the transceiver unit 1120 is further configured to send the codeword corresponding to the quantized data.

In a possible implementation, the processing unit 1110 is further configured to determine a second codebook, where the second codebook is for quantizing second data; and the transceiver unit 1120 is further configured to send second indication information, where the second indication information indicates the second codebook.

In a possible implementation, the first data and the second data correspond to a same artificial intelligence model.

When the communication apparatus 1100 is configured to implement a function of the second apparatus in the foregoing method embodiment, the transceiver unit 1120 is configured to receive first indication information, where the first indication information indicates the first codebook, and the first codebook is for quantizing first data; and the processing unit 1110 is configured to determine the first codebook based on the first indication information.

In a possible implementation, the transceiver unit 1120 is further configured to receive a codeword corresponding to quantized data, where the quantized data is obtained by quantizing the first data.

In a possible implementation, the processing unit 1110 is further configured to determine the quantized data based on the first codebook and the codeword corresponding to the quantized data.

In a possible implementation, the transceiver unit 1120 is further configured to: receive first information, where the first information indicates a part or all of codebooks in a first codebook set; and send second information, where the second information indicates that a part or all of the codebooks indicated by the first information are used, and the codebook indicated by the second information includes the first codebook.

In a possible implementation, a transmission overhead corresponding to the codebook indicated by the first information is less than a transmission overhead threshold.

In a possible implementation, the transmission overhead includes a codebook indication overhead and/or a data transmission overhead for quantized first data.

In a possible implementation, a quantization error of the codebook in the first codebook set is less than or equal to a quantization error threshold.

In a possible implementation, the quantization error threshold is preconfigured or predefined.

In a possible implementation, the quantization error threshold is related to an importance degree of the first data.

In a possible implementation, the transceiver unit 1120 is further configured to send third information, where the third information indicates the first codebook.

In a possible implementation, the first codebook satisfies a preset modulation and coding scheme MCS requirement.

In a possible implementation, the first data is associated with a first service, a first data radio bearer, or a first logical channel.

In a possible implementation, the transceiver unit 1120 is further configured to receive second indication information, where the second indication information indicates a second codebook, and the second codebook is for quantizing second data; and the processing unit 1110 is further configured to determine the second codebook based on the second indication information.

In a possible implementation, the first data and the second data correspond to a same artificial intelligence model.

For more detailed descriptions about the processing unit 1110 and the transceiver unit 1120, directly refer to the related descriptions in the foregoing method embodiments. Details are not described herein again.

A communication apparatus 1200 shown in FIG. 12 includes a processor 1210 and an interface circuit 1220. The processor 1210 and the interface circuit 1220 are coupled to each other. It may be understood that the interface circuit 1220 may be a transceiver or an input/output interface. Optionally, the communication apparatus 1200 may further include a memory 1230, configured to store instructions executed by the processor 1210, input data required by the processor 1210 to run the instructions, or data generated after the processor 1210 runs the instructions. Alternatively, when the processor is a logic circuit (device), the memory 1230 is configured to store a configuration file of the logic circuit (device).

When the communication apparatus 1200 is configured to implement the foregoing method embodiments, the processor 1210 is configured to implement a function of the processing unit 1110, and the interface circuit 1220 is configured to implement a function of the transceiver unit 1120.

It may be understood that the processor in embodiments of this application may be a central processing unit (central processing unit, CPU), or may be another general-purpose processor, a digital signal processor (digital signal processor, DSP), an application-specific integrated circuit (application-specific integrated circuit, ASIC), a field programmable gate array (field programmable gate array, FPGA) or another programmable logic device, a transistor logic device, a hardware component, or any combination thereof. The general-purpose processor may be a microprocessor or any regular processor or the like.

The method steps in embodiments of this application may be implemented in a hardware manner, or may be implemented in a manner of executing software instructions by the processor. The software instruction may be composed of corresponding software modules. The software modules may be stored in a random access memory, a flash memory, a read-only memory, a programmable read-only memory, an erasable programmable read-only memory, an electrically erasable programmable read-only memory, a register, a hard disk drive, a removable hard disk, and a compact optical disk read-only memory (compact disc read-only memory, CD-ROM) or any other form of storage medium well known in the art. For example, a storage medium is coupled to a processor, so that the processor can read information from the storage medium and write information into the storage medium. Certainly, the storage medium may be a component of the processor. The processor and the storage medium may be disposed in an ASIC. In addition, the ASIC may be located in the first apparatus or the second apparatus. Certainly, the processor and the storage medium may alternatively exist in the first apparatus or the second apparatus as discrete components.

All or some of the foregoing embodiments may be implemented by using software, hardware, firmware, or any combination thereof. When software is used to implement the foregoing embodiments, all or some of the foregoing embodiments may be implemented in a form of a computer program product. The computer program product includes one or more computer programs or instructions. The computer program (computer program) is a set of instructions that indicate each step of an electronic computer or another device having a message processing capability, and is usually written in a program design language and run on a target architecture. When the computer programs or the instructions are loaded and executed on a computer, all or some of the procedures or functions in embodiments of this application are executed. The computer may be a general-purpose computer, a dedicated computer, a computer network, a network device, a terminal device, or another programmable apparatus. The computer program or instructions may be stored in a computer-readable storage medium, or may be transmitted from a computer-readable storage medium to another computer-readable storage medium. For example, the computer program or instructions may be transmitted from a website, computer, server, or data center to another website, computer, server, or data center in a wired or wireless manner. The computer-readable storage medium may be any usable medium that can be accessed by the computer, or a data storage device, for example, a server or a data center, integrating one or more usable media. The usable medium may be a magnetic medium, for example, a floppy disk, a hard disk drive, or a magnetic tape; or may be an optical medium, for example, a digital video disc; or may be a semiconductor medium, for example, a solid-state drive. The computer-readable storage medium may be a volatile or non-volatile storage medium, or may include two types of storage media: a volatile storage medium and a non-volatile storage medium.

In various embodiments of this application, unless otherwise stated or there is a logic conflict, terms and/or descriptions in different embodiments are consistent and may be mutually referenced, and technical features in different embodiments may be combined based on an internal logical relationship thereof, to form a new embodiment.

In this application, at least one means one or more, and a plurality of means two or more. The term "and/or" describes an association relationship between associated objects, and represents that three relationships may exist. For example, A and/or B may represent the following cases: Only A exists, both A and B exist, and only B exists, where A and B may be singular or plural. In the text descriptions of this application, the character "/" indicates an "or" relationship between the associated objects. In a formula in this application, the character "/" indicates a "division" relationship between the associated objects.

It may be understood that various numbers in embodiments of this application are merely used for differentiation for ease of description, and are not used to limit the scope of embodiments of this application. Sequence numbers of the foregoing processes do not mean an execution sequence, and the execution sequence of the processes should be determined based on functions and internal logic of the processes.

## Claims

1. A communication method, comprising:
determining a first codebook, wherein the first codebook is for quantizing first data; and
sending first indication information, wherein the first indication information indicates the first codebook.

2. The method according to claim 1, wherein determining the first codebook comprises:
determining a first codebook set based on a distribution feature of the first data, wherein the first codebook set comprises at least one codebook; and
determining the first codebook in the first codebook set.

3. The method according to claim 2, wherein determining the first codebook in the first codebook set comprises:
determining the first codebook based on a transmission overhead corresponding to the codebook in the first codebook set.

4. The method according to claim 3, wherein the transmission overhead comprises a codebook indication overhead and/or a data transmission overhead for quantized first data.

5. The method according to claim 2, wherein determining the first codebook in the first codebook set comprises:
sending first information, wherein the first information indicates a part or all of codebooks in the first codebook set;
receiving second information, wherein the second information indicates that a part or all of the codebooks indicated by the first information are used; and
determining the first codebook based on the second information.

6. The method according to claim 5, wherein a transmission overhead corresponding to the codebook indicated by the first information is less than a transmission overhead threshold.

7. The method according to claim 2, wherein determining the first codebook in the first codebook set comprises:
receiving third information, wherein the third information indicates the first codebook.

8. The method according to any one of claims 2 to 7, wherein a quantization error of the codebook in the first codebook set is less than or equal to a quantization error threshold.

9. The method according to claim 8, wherein the quantization error threshold is preconfigured or predefined.

10. The method according to claim 8 or 9, wherein the quantization error threshold is related to an importance degree of the first data.

11. The method according to any one of claims 2 to 10, wherein determining the first codebook set based on the distribution feature of the first data comprises:
determining, based on the distribution feature of the first data and a mapping relationship between the distribution feature and a codebook, the first codebook set that is in the mapping relationship and that corresponds to the distribution feature of the first data.

12. The method according to any one of claims 2 to 11, wherein the distribution feature of the first data comprises a data distribution slope and/or a data expectation.

13. The method according to any one of claims 1 to 12, wherein the first codebook satisfies a preset modulation and coding scheme MCS requirement.

14. The method according to any one of claims 1 to 13, wherein the first data is associated with a first service, a first data radio bearer, or a first logical channel.

15. The method according to any one of claims 1 to 14, wherein the method further comprises:
quantizing the first data to obtain quantized data;
determining, based on the first codebook, a codeword corresponding to the quantized data; and
sending the codeword corresponding to the quantized data.

16. The method according to any one of claims 1 to 15, wherein the method further comprises:
determining a second codebook, wherein the second codebook is for quantizing second data; and
sending second indication information, wherein the second indication information indicates the second codebook.

17. The method according to claim 16, wherein the first data and the second data correspond to a same artificial intelligence model.

18. A codebook determining method, comprising:
receiving first indication information, wherein the first indication information indicates a first codebook, and the first codebook is for quantizing first data; and
determining the first codebook based on the first indication information.

19. The method according to claim 18, wherein the method further comprises:
receiving a codeword corresponding to quantized data, wherein the quantized data is obtained by quantizing the first data.

20. The method according to claim 19, wherein the method further comprises:
determining the quantized data based on the first codebook and the codeword corresponding to the quantized data.

21. The method according to any one of claims 18 to 20, wherein the method further comprises:
receiving first information, wherein the first information indicates a part or all of codebooks in a first codebook set; and
sending second information, wherein the second information indicates that a part or all of the codebooks indicated by the first information are used, and the codebook indicated by the second information comprises the first codebook.

22. The method according to claim 21, wherein a transmission overhead corresponding to the codebook indicated by the first information is less than a transmission overhead threshold.

23. The method according to claim 22, wherein the transmission overhead comprises a codebook indication overhead and/or a data transmission overhead for quantized first data.

24. The method according to any one of claims 21 to 23, wherein a quantization error of the codebook in the first codebook set is less than or equal to a quantization error threshold.

25. The method according to claim 24, wherein the quantization error threshold is preconfigured or predefined.

26. The method according to claim 24 or 25, wherein the quantization error threshold is related to an importance degree of the first data.

27. The method according to any one of claims 18 to 20, wherein the method further comprises:
sending third information, wherein the third information indicates the first codebook.

28. The method according to any one of claims 18 to 27, wherein the first codebook satisfies a preset modulation and coding scheme MCS requirement.

29. The method according to any one of claims 18 to 28, wherein the first data is associated with a first service, a first data radio bearer, or a first logical channel.

30. The method according to any one of claims 18 to 29, wherein the method further comprises:
receiving second indication information, wherein the second indication information indicates a second codebook, and the second codebook is for quantizing second data; and
determining the second codebook based on the second indication information.

31. The method according to claim 30, wherein the first data and the second data correspond to a same artificial intelligence model.

32. A communication apparatus, comprising:
at least one processor, configured to run at least one of the following: computer instructions, a program, or a logic circuit, to enable the communication apparatus to perform the data transmission method according to any one of claims 1 to 17, or perform the data transmission method according to any one of claims 18 to 31.

33. A communication system, comprising a first apparatus configured to perform the method according to any one of claims 1 to 17, and a second apparatus configured to perform the method according to any one of claims 18 to 31.

34. A computer program product, wherein the computer program product comprises a computer program or instructions, and when the computer program or the instructions are run by a communication apparatus, the method according to any one of claims 1 to 17 or the method according to any one of claims 18 to 31 is performed.

35. A computer-readable storage medium, wherein the storage medium stores a computer program or instructions, and when the computer program or the instructions are executed by a communication apparatus, the method according to any one of claims 1 to 17 is implemented or the method according to any one of claims 18 to 31 is implemented.
